# EUROPÄISCHE PATENTANMELDUNG

(11) **EP 1 988 609 A2**
(43) Veröffentlichungstag der Anmeldung: **05.11.2008**
(21) Anmeldenummer: 08008108.6
(22) Anmeldetag: 28.04.2008
(51) Int. Cl.: H01R 13/703

(54) **Steckverbindung für Schaltungsträger**

(30) Priorität: 03.05.2007 DE 202007006357 U
(71) Anmelder: Harting AG, 2500 Biel 6 (CH)
(72) Erfinder: Krause, Jens, Dr., 32369 Rahden (DE)
(74) Vertreter: Sties, Jochen

(57) **Zusammenfassung**

Für eine steckbare Verbindung zu einem MID-Körper, einem räumlich spritzgegossenen Schaltungsträger, wird vorgeschlagen, an dem Schaltungsträger (1) eine Anformung (3) vorzusehen, auf der Leiterbahnen (13) aufgebracht sind, die von einem entsprechend geformten Stecker (20) kontaktiert werden. Dazu weist die Anformung (3) einen Haltebereich (5) mit einer umlaufenden Dichtung (16) und einen Steckbereich (7) auf.
Der entsprechend ausgebildeter Stecker (20) weist gabelförmige Steckkontakte (27) auf, die den Steckbereich (7) kontaktieren, wobei das Steckergehäuse (22) mittels der umlaufenden Dichtung (16) in einer gesteckten Position abgedichtet und gehalten wird.

## Beschreibung

Die Erfindung betrifft eine Steckverbindung für räumlich spritzgegossene Schaltungsträger, bestehend aus dem Schaltungsträger mit einer daran ausgebildeten Anformung zur elektrischen Kontaktierung mit einem dazu vorgesehenen Stecker.

Eine derartige Steckverbindung ist zweckmäßig, um bei räumlich spritzgegossenen Schaltungsträgern (MID-Konstrukte) externe oder interne Signale oder eine Strom/Spannungsversorgung mit einer lösbaren Kontaktierung abzugreifen oder zuzuführen.

### Stand der Technik

Ein wesentlicher Punkt bei der Nutzung der MID-Technologie ist die Zusammenführung mechanischer und elektrischer Funktionen in einem Bauteil, wobei hier durch eine Reduzierung der Einzelteile der Montageaufwand gesenkt und die Prozesskette verkürzt wird, was zu einer Verringerung der Fertigungskosten und einer Verkleinerung der elektronischen Baugruppen führt.

### Aufgabenstellung

Der Erfindung liegt die Aufgabe zugrunde, eine Steckverbindung für sogenannte MID-Produkte zu realisieren, die bei möglichst einfachem Aufbau eine lösbare Anbindung an eine in einem Schaltungsträger integrierte elektrische/elektronische Schaltung bietet.

Diese Aufgabe wird dadurch gelöst, dass die Anformung einen Haltebereich und einen Steckbereich umfasst, und dass aus dem Schaltungsträger bis in den Steckbereich mindestens eine den Konturen der Anformung angepasste Leiterbahn zur Kontaktierung von mindestens einem in einem dazu vorgesehenen Stecker angeordneten, steckseitig gabelförmigen Steckkontakt vorgesehen ist.

Vorteilhafte Ausgestaltungen der Erfindung sind in den Ansprüchen 2 - 6 angegeben.

Die mit der Erfindung erzielten Vorteile bestehen insbesondere darin, dass durch eine wesentliche Reduzierung von sonst üblichen Bauteilen für einen Steckverbinder eine sehr kostengünstige steckbare Verbindung zu einem räumlich spritzgegossenen Schaltungsträger realisierbar ist.
Durch die Nutzung von entsprechend hochtemperatursicheren Thermoplasten und deren strukturierbare Metallisierung eröffnen sich neue Dimensionen von Schaltungsträgern: räumliche spritzgegossene Schaltungsträger. (3-D MID, 3-D Molded Interconnect Devices).
MIDs sind Formteile mit einer integrierten Leiterbahnenstruktur.
So ist einer der beiden für eine Steckverbindung erforderlichen Steckerteile aus dem Schaltungsträger heraus geformt, während der Gegenstecker eine äußerst vereinfachte Struktur für die Kontaktierung wie für die Halterung an dem Schaltungsträger aufweist.
Die Anformung ist derartig ausgeführt, dass aus einem etwa quaderförmigen Steckerkörper ein Steckbereich aus hier drei nebeneinander angeordneten Kammern, vorteilhaft durch Trennwände abgeteilt, gebildet ist. Zwischen den Trennwänden ist jeweils eine Leiterbahn aufgebracht, die der Formgebung der Anformung als solches folgt.
Weiterhin ist eine vorteilhafte Haftung zwischen den Steckkontakten und das sie umgebende Gehäuse vorgesehen, wobei die Steckkontakte Widerhaken aufweisen, die sich in das zu umspritzende Material des Steckergehäuses einkrallen und zusammen mit einer bundartigen Anformung an einer steckseitigen Kante der Steckkontakte eine optimale Verbindung zwischen Steckergehäuse und Steckkontakten ergeben.

Der Stecker ist kostengünstig sehr einfach konstruiert, in dem gabelförmige Kontakte, verbunden mit elektrischen Leitern in einem isolierenden Gehäuse, zumindest teilweise umspritzt, angeordnet sind.
Zur Abdichtung und Halterung des Steckers ist optional auf der Anformung ein elastisches Element aufgeschoben, wie es in ähnlicher Form zur wasserdichten Abschirmung von Kontakten oder Steckern bereits standardmäßig genutzt wird.

### Ausführungsbeispiel

Ein Ausführungsbeispiel der Erfindung ist in der Zeichnung dargestellt und wird im folgenden näher erläutert. Es zeigen:
- Fig. 1: eine isometrische Darstellung eines Schaltungsträgers mit einer Anformung,
- Fig. 2: eine isometrische Schnittdarstellung der Anformung mit einem dazu vorgesehenen Stecker ohne Steckergehäuse,
- Fig. 3: eine isometrische Schnittdarstellung der Anformung mit einem dazu vorgesehenen Stecker mit Steckergehäuse, und
- Fig. 4: ein aufgesteckter Stecker.

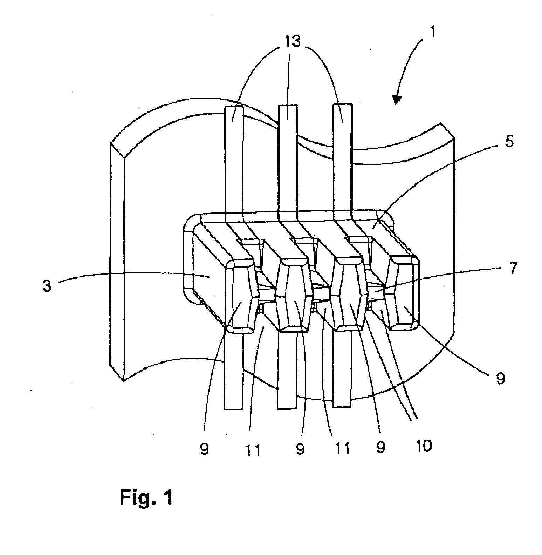

In der Fig. 1 ist in einer isometrischen Darstellung ein Teil eines räumlich spritzgegossenen Schaltungsträgers 1 ersichtlich, wobei dessen Funktion hier unwesentlich ist.
An dem Schaltungsträger 1 ist eine quaderförmige Anformung 3 vorgesehen, die einen Haltebereich 5 und einen Steckbereich 7 für einen daran angepassten Stecker 20 aufweist.
Dabei ist der Steckbereich 7 abgestuft und über einen Übergangsbereich 6 verjüngt gegenüber dem Haltebereich 5 ausgeformt.

Den Steckbereich bilden hier 3 Kammern, in denen elektrisch leitende Leiterbahnen 13 vorgesehen sind, die durch Trennwände 9 voneinander getrennt sind.
Wobei die Trennwände 9 die gleiche Höhe aufweisen, die der Dicke des Haltebereiches 5 entspricht. Dabei können die inneren Trennwände zu den Leiterbahnen 13 trapezförmig ausgebildete Schrägen 10 aufweisen.

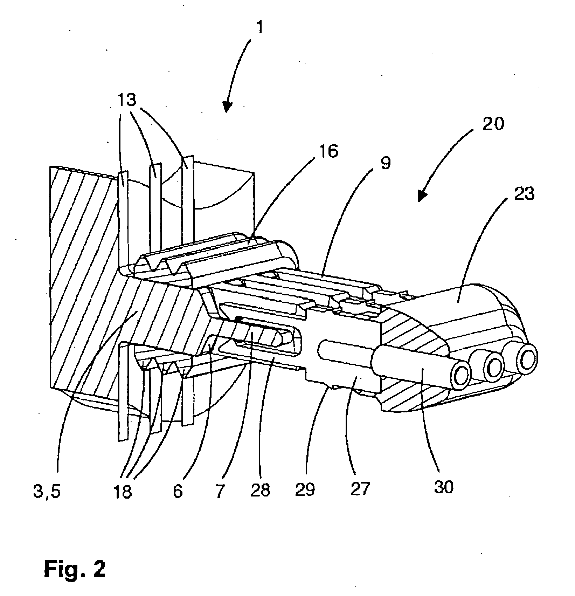

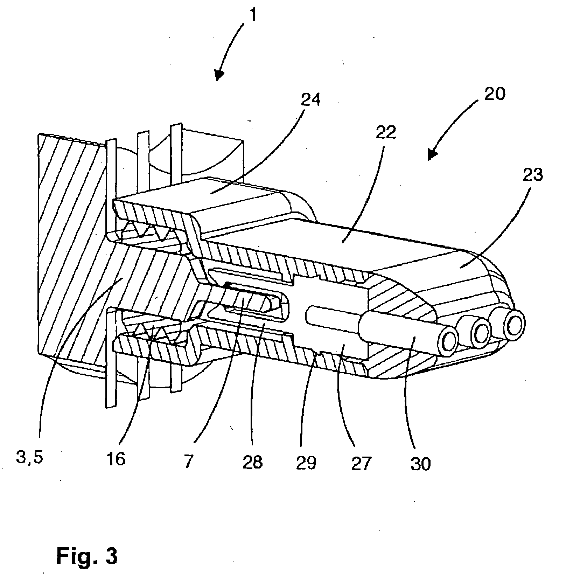

In der Fig. 2, einer ebenfalls perspektivischen Darstellung mit einem Schnitt unmittelbar an einer äußeren Leiterbahn 13, wobei die äußere Trennwand 11 "entfernt" wurde, ist der Schaltungsträger 1 mit der Anformung 3, mit auf den Steckbereich 7 aufgeschobenen Steckkontakten 27 eines Steckers 20 ohne dessen Gehäuse 22 dargestellt.
Der Stecker 20 umfasst drei Steckkontakte 27, die jeweils mit einem elektrischen Leiter 30 verbunden sind, zusammen mit einem erst im letzten Arbeitsgang umspritzten Endstückes 23, das zumindest bereichsweise die Steckkontakte und die elektrischen Leiter umgibt.
Die Steckkontakte 27 weisen einen an den Steckbereich 7 der Anformung 3 angepassten gabelförmigen Kontaktbereich 28 auf, mit dem sie jeweils eine Seite der Leiterbahn 13 umfassen, die schleifenförmig um den Steckbereich 7 herumgeführt ist.
Weiterhin sind an den Steckkontakten 27 Widerhaken 29 vorgesehen, die wie aus der Fig. 3 ersichtlich, neben der bundartigen Anformung 25 an dem Gehäuse 22 einen sicheren Halt der Steckkontakte im Gehäuse 22 gewährleisten.

Dazu wird bei der Steckerfertigung zunächst das Steckergehäuse 22 mit entsprechenden, hier nicht gezeigten, Durchgangsschlitzen für die Steckkontakte 27 gefertigt. Anschließend werden die Steckkontakte mit den bereits angefügten elektrischen Leitern 30 in diese Durchgangsschlitze eingefügt und abschließend mit einem Kunststoffpfropfen, dem Endstück 23 vergossen, so dass auch noch ein Teil des Kunststoffes in die Schlitze mit eindringt. Somit übernimmt das Endstück 23 eine zusätzliche mechanische Halterung der Steckkontakte mit den elektrischen Leitern 30.

Das Gehäuse 22 des Steckers 20 ist steckseitig mit einem entsprechend der übrigen, letztlich rechteckigen Gehäuseform erweiterten Kragen 24 versehen.
Der Kragen 24 wird beim Steckvorgang des Steckers 20 auf die Anformung 3 des Schaltungsträgers 1 auf eine auf dem Haltebereich 5 aufgezogene Dichtung 16 aufgeschoben.
Diese aus flexiblem Material geformte Dichtung 16, weist nach außen wirkend, drei quer zur Steckrichtung ausgerichtete Rippen 18 auf, so dass zum einen eine Haltefunktion, speziell aber eine gegen Umwelteinflüsse weitgehend abdichtende Wirkung erzielt wird.

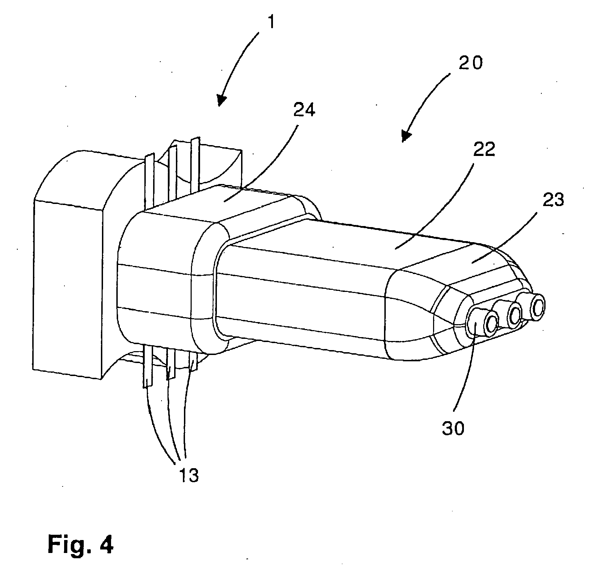

Die Fig. 4 zeigt einen kompletten Stecker 20, der auf der Anformung 3 eines Schaltungsträgers 1 aufgeschoben ist.

### Bezugszeichenliste

### MID-Steckverbindung

### Az.: 207-03 EP P MI

- **1**: **Schaltungsträger**
- 2:
- 3: Anformung
- 4:
- 5: Haltebereich
- 6: Übergangsbereich
- 7: Steckbereich
- 8:
- 9: Trennwände
- 10: Schrägen
- 11: Kammer
- 12:
- 13: Leiterbahn
- 14:
- 15:
- **16**: **Dichtung**
- 17:
- 18: Rippen
- 19:

- **20**: **Stecker**
- 21:
- 22: Steckergehäuse
- 23: Endstück
- 24: Kragen
- 25: Anformung
- 26:
- **27**: **Steckkontakt**
- 28: Kontaktbereich, gabelförmig
- 29: Widerhaken

- **30**: **elektr. Leiter**

## Patentansprüche

1. Steckverbindung für räumlich spritzgegossene Schaltungsträger, bestehend aus dem Schaltungsträger (1) mit einer daran ausgebildeten Anformung (3) zur elektrischen Kontaktierung mit einem dazu vorgesehenen Stecker (20), **dadurch gekennzeichnet,**
**dass** die Anformung (3) einen Haltebereich (5) und einen Steckbereich (7) umfasst, und
**dass** aus dem Schaltungsträger (1) bis in den Steckbereich (7) mindestens eine den Konturen der Anformung (3) angepasste Leiterbahn (13) zur Kontaktierung von mindestens einem in einem dazu vorgesehenen Stecker (20) angeordneten, steckseitig gabelförmigen Steckkontakt (27) vorgesehen ist.

2. Steckverbindung nach Anspruch 1, **dadurch gekennzeichnet,**
**dass** der Steckbereich (7) mehrere durch Trennwände (9) separierte Kammern (11) aufweist, in denen die elektrisch leitende Leiterbahnen (13) angeordnet sind.

3. Steckverbindung nach Anspruch 1, **dadurch gekennzeichnet,**
**dass** der Steckbereich (7) innerhalb der Kammer (11) gegenüber dem Haltebereich (5) stufenförmig verjüngt ausgeformt ist.

4. Stecker für die Steckverbindung nach Anspruch 1, **dadurch gekennzeichnet,**
**dass** der Steckkontakt (27) mit einem elektrischen Leiter (30) verbunden ist und diese jeweils zumindest abschnittsweise von einem sie umgebenden Endstück (23) umhüllt sind.

5. Stecker für die Steckverbindung nach Anspruch 4, **dadurch gekennzeichnet,**
**dass** der Steckkontakt (27) Widerhaken (29) aufweist, so dass eine sichere Befestigung in einem umspritzen Gehäuse gewährleistet ist.

6. Anformung für die Steckverbindung nach Anspruch 1, **dadurch gekennzeichnet,**
**dass** auf dem Haltebereich (5) der Anformung (3) eine elastische, umlaufende Dichtung (16) mit quer zur Steckrichtung ausgebildeten Rippen angeordnet ist, auf die der Stecker (20) mit einem umlaufenden Kragen (24) aufschiebbar ist, so dass eine umweltdichte Verbindung für den Steckbereich (7) zwischen dem Schaltungsträger (1) und dem Stecker (20) gebildet ist.
